# EUROPEAN PATENT APPLICATION

(11) **EP 2 471 640 A1**
(43) Date of publication of application: **04.07.2012**
(21) Application number: 11156875.4
(22) Date of filing: 03.03.2011
(51) Int. Cl.: B28D 5/04

(54) **Cooling device for diamond-wire cutting system**

(30) Priority: 31.12.2010 TW 099147097
(71) Applicant: Micron Diamond Wire & Equipment Co., Ltd., New Taipei City 241 (TW)
(72) Inventor: Lee, Cheng Ming, New Taipei City 241 (TW)
(74) Representative: Hellmich, Wolfgang

(57) **Abstract**

A cooling device for a diamond-wire cutting system includes a fluid retarding space as a cooling tank enclosed and defined by one or more surfaces for temporarily holding a cooling fluid. The surfaces provide a closed or semi-open sidewall that allows a cutting part of a diamond wire for cutting a workpiece to pass through the cooling tank and get immersed in the cooling fluid. A sorting collector is connected to the cooling tank. Thereby, cutting the hard-brittle workpiece is always performed in the cooling fluid, so as to prevent the cooling fluid and cutting chips from splashing, and improve heat dissipation and dust removal, thereby enhancing the cutting capability and efficiency. The tooled workpiece has cut surfaces with improved smoothness. The sorting collector performs solid-liquid separation to the cooling fluid containing cutting chips, so that the cutting chips and the cooling fluid can be recycled.

## Description

### BACKGROUND OF THE INVENTION

### 1. TECHNICAL FIELD

The present invention relates to a cooling device for a diamond-wire cutting system that cuts hard-brittle materials. In use, a diamond wire for cutting and a workpiece to be cut are both sunk in a cooling tank of the cooling device that is filled with a cooling fluid. The disclosed cooling device thus improves the cutting capability and efficiency of the diamond-wire cutting system, while having advantages of reducing wear and tear caused to the diamond wire, improving the smoothness of the cut surface of the workpiece, preventing the cooling fluid and cutting chip from splashing, and facilitating collection and recycling of the cutting chips.

### 2. DESCRIPTION OF RELATED ART

Cutting hard-brittle workpieces, such as monocrystalline & polycrystalline silicon ingots, GaAs ingots, quartz glass ingots and other hard-brittle materials would be difficult because they are usually highly rigid, less conductive and brittle. For example, efficiency of silicon ingot cutting mainly relies on the productivity of the wire saw which is defined by the number of silicon wafers produced in a unit time. In addition, the load of the cutting device, the cutting speed, the diameter of the cutting wire, and device maintenance all greatly affect the cutting efficiency. For instance, higher cutting speed and larger load increase the tension of the cutting wire, which may in turn cause the cutting wire likely to break, and may cause part of the cut silicon wafers defective, rendering waste. In addition, a cutting wire with an excessively large diameter can unnecessarily consume the silicon ingots to be cut. Whereas, a cutting wire with a too small diameter tends to break, thus seriously affect the efficiency by frequently changing the wire. Besides, despite of the thickness of the silicon wafers to be made, no injury (e.g. minute cracks, wire marks) or damaged layer is acceptable on the tooled surface. Also, desirably, the demand for subsequent surface treatment of the tooled surface, such as polishing, is minimized.

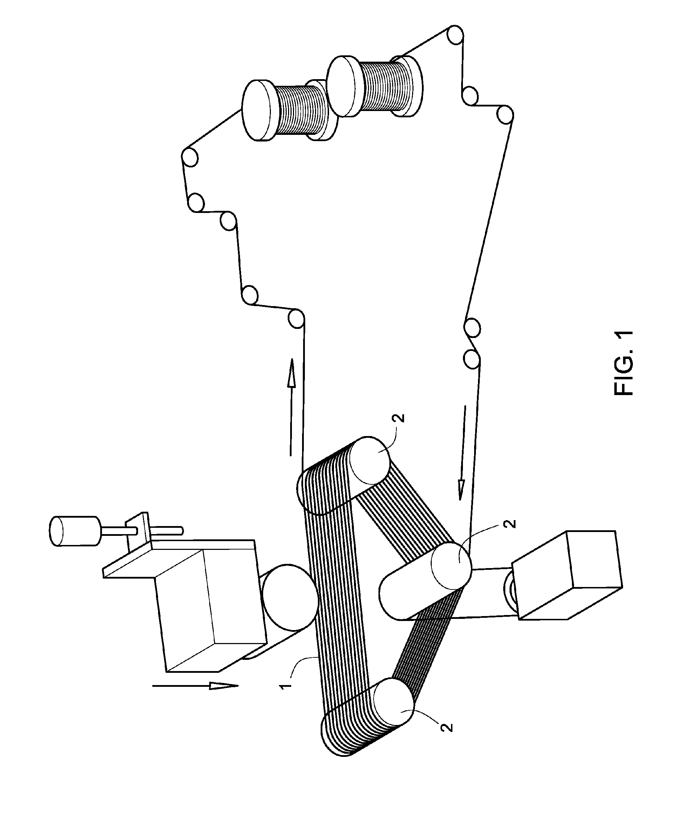

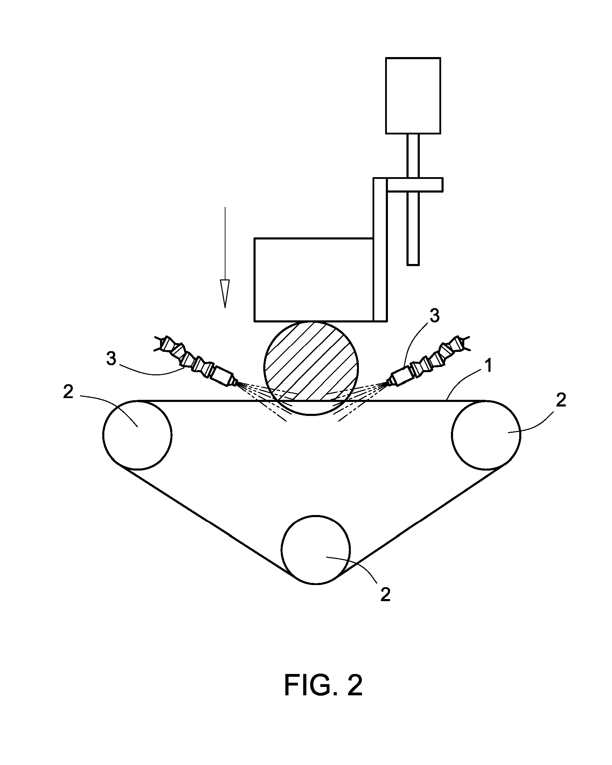

Only when all the aforementioned factors are well balanced, the maximum yield is possible. Without precise management, wire cutting can cause the resultant wafers having minute cracks or warpage, which adversely affects the yield. For enhancing a wire-cutting system in terms of cutting speed, cutting pressure and load, it is important to provide consistent cooling. Referring to FIG. 1, a diamond wire 1 for cutting is wound around a plurality of rollers 2, so as to continuous tool a hard-brittle workpiece. The worn diamond wire 1 can be taken up into a roll. Such a system is time-effective and allows multi-wafer tooling. As shown in FIG. 2, nozzles 3 for spraying a cooling fluid are provided about a site of cutting, so that the cooling fluid is introduced to the site of cutting, with the attempt to dissipate the heat generated during cutting and to wash off cutting chips from the diamond wire 1 and the workpiece, thereby improving cutting capability of the cutting system and tooled surfaces of the workpiece while effectively preventing warpage or deformation from happening to the workpiece.

However, the diamond wire 1 is only showered and cooled by the cooling fluid at the cutting site where the hard-brittle workpiece is tooled. After the brief contact, the diamond wire 1 leaves the cooling fluid immediately. Or, in the cutting kerf, since air is blocked from escaping, the cooling fluid is barricaded from entering the kerf. Consequently, the cooling effect on the diamond wire 1 is exactly limited, and this threatens the cutting system with degraded cutting capability and speed of the diamond wire 1 as well as defective tooled surfaces of the workpiece.

Moreover, when the diamond wire 1 cuts a workpiece in high speed, since the workpiece is usually hard and brittle, cutting chips and dust can be generated. With the presence of such cutting chips and dust, the cooling fluid injected to the cutting site can beat the diamond wire 1 and splash around, causing the cutting chips and the used cooling fluid not easy to collect and recycle.

### SUMMARY OF THE INVENTION

In order to improve the cutting capability and speed of a diamond wire in a diamond-wire cutting system as well as the smoothness of the tooled surfaces of a workpiece cut by the diamond wire, the present invention provides a cooling device for a diamond-wire cutting system that cuts a hard-brittle workpiece, wherein a part of a diamond wire to cut always submerges in a cooling fluid contained in a cooling tank that includes a fluid retarding space for temporarily holding the cooling fluid, so that the diamond wire can cut the hard-brittle workpiece better, and can serve longer.

To this end, the cooling system of the present invention comprises a fluid retarding space that holds a cooling fluid temporarily, so that a diamond wire can have its cutting part passing through the fluid retarding space, thereby making the cutting part of the diamond wire stay in the cooling fluid.

In the foregoing scheme, the fluid retarding space is enclosed and therefore defined by a consecutive surface.

In the foregoing scheme, the fluid retarding space is enclosed and therefore defined by a plurality of surfaces.

In the foregoing scheme, the surface or the surfaces enclosing the fluid retarding space as a cooling tank that has a continuous side wall or a semi-open side wall.

In the foregoing cooling device, the cooling tank has its bottom connected to a sorting collector. The sorting collector has a fluid recycling pipe running back to the cooling tank and a chip recycling pipe for reclaiming the collected chips.

According to the present invention, since the diamond wire is sunk in the cooling fluid, when the diamond wire cuts the hard-brittle workpiece, the site of cutting is always soaked in the cooling fluid, thereby improving heat dissipation and dust removal, reducing damages to the diamond wire, enhancing the cutting efficiency of the diamond wire cutting the hard-brittle workpiece, improving the smoothness of the tooled surface of the workpiece, and preventing cutting chips and the cooling fluid from splashing during cutting. Moreover, the sorting collector serves to perform solid-liquid separation to the used cooling fluid containing cutting chips, so that the cooling fluid with the cutting chips removed can be recycled for reuse, and the cutting chips can be collected to be processed or recycled.

### BRIEF DESCRIPTION OF THE DRAWINGS

The invention as well as a preferred mode of use, further objectives and advantages thereof will be best understood by reference to the following detailed description of illustrative embodiments when read in conjunction with the accompanying drawings, wherein:
FIG. 1 is a schematic drawing of a conventional cutting device for hard-brittle materials;
FIG. 2 is a schematic drawing of a conventional cooling device for a cutting device that cuts hard-brittle materials;
FIG. 3 is a schematic drawing of a cooling device for a diamond-wire cutting system according to the present invention;
FIG. 4 is a second embodiment of a fluid retarding space as a cooling tank according to the present invention that includes;
FIG. 5 is a third embodiment of a fluid retarding space as a cooling tank according to the present invention that includes;
FIG. 6 shows a first aspect of the fluid retarding space;
FIG. 7 shows a second aspect of the fluid retarding space;
FIG. 8 shows a third aspect of the fluid retarding space;
FIG. 9 shows a fourth aspect of the fluid retarding space.

### DETAILED DESCRIPTION OF THE INVENTION

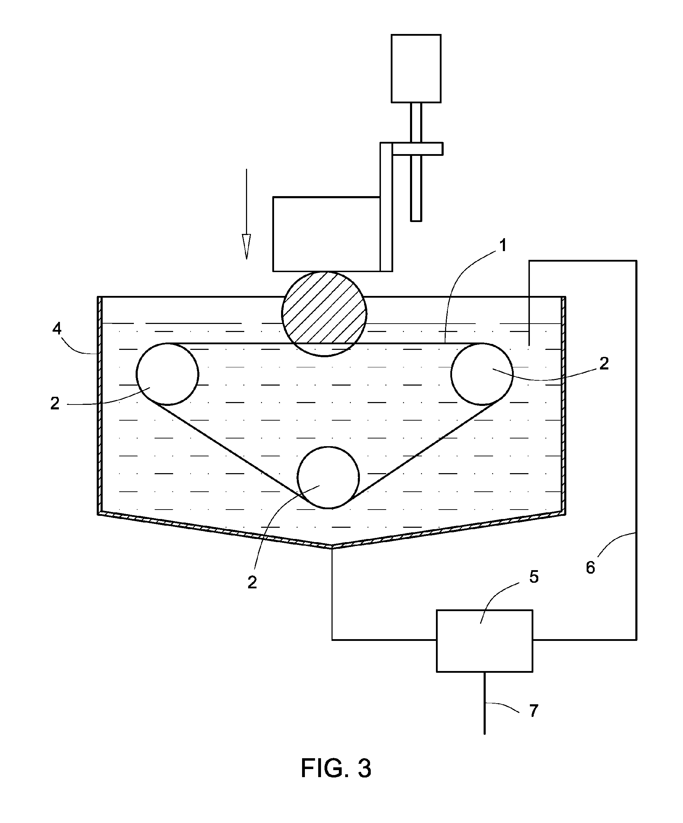

Referring to FIG. 3, the present invention proposes a cooling device for a diamond-wire cutting system. The cooling device includes a cooling tank 4. The cooling tank 4 defines a fluid retarding space for temporarily holding a cooling fluid, so that a diamond wire 1 may have its cutting part submerging in the cooling fluid.

In addition, a sorting collector 5 is connected to a bottom of the cooling tank 4. The sorting collector 5 is equipped with a fluid recycling pipe 6 that leads back to the cooling tank 4, and the sorting collector 5 also connects with a chip recycling pipe 7 at a bottom thereof.

Thereby, a part of a hard-brittle workpiece to be cut and the part of the diamond wire 1 to cut are always sunk in the cooling fluid, so that heat and cutting chips generated by cutting the hard-brittle workpiece can be dissipated and removed promptly by the flowing cooling fluid, thereby enhancing the cutting efficiency of the diamond wire 1 to the hard-brittle workpiece and improving smoothness of the newly cut surface of the hard-brittle workpiece, which reduces the need for subsequent surface treatment, such as polishing while lengthening the service life of the diamond wire 1.

Moreover, since the part of the hard-brittle workpiece to be cut is always sunk in the cooling fluid, dust and chips generated when the diamond wire 1 cuts the hard-brittle workpiece are retained by the cooling fluid from escaping to the ambient air, so that the cutting process is free from the trouble caused by flying dust and splashing cooling fluid. The cutting chips are then settled at the bottom of the cooling tank 4 by gravity for the sorting collector 5 to separate the cutting chips from the cooling fluid. The cooling fluid with the cutting chips removed is afterward introduced into the cooling tank 4 by way of the recycling pipe 6 while the chips go along the chip recycling pipe 7 to be recycled.

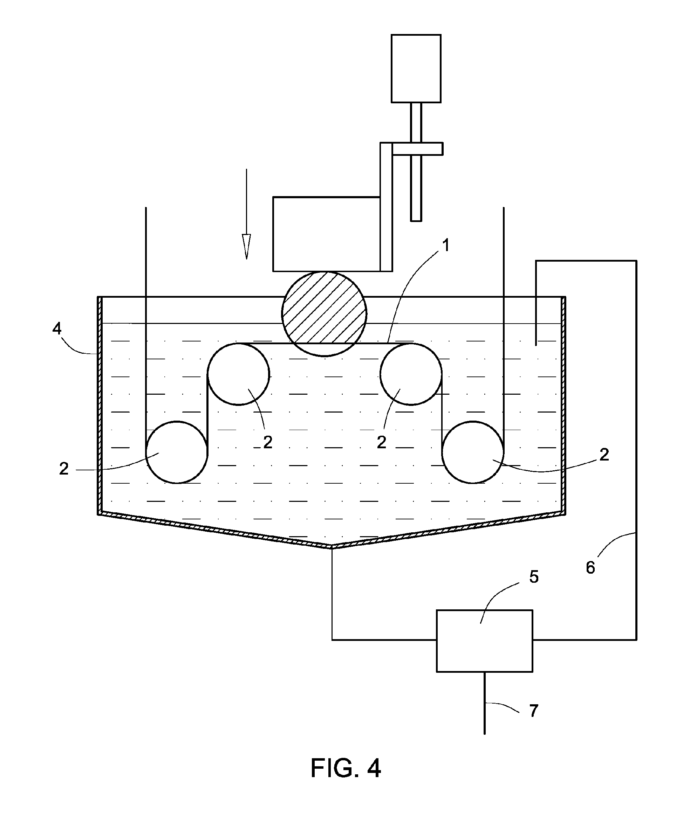

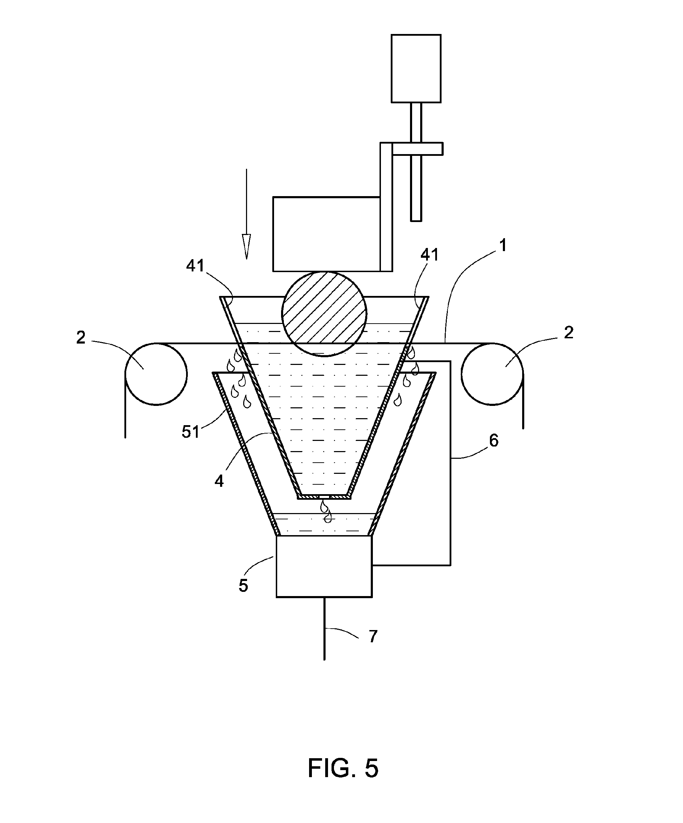

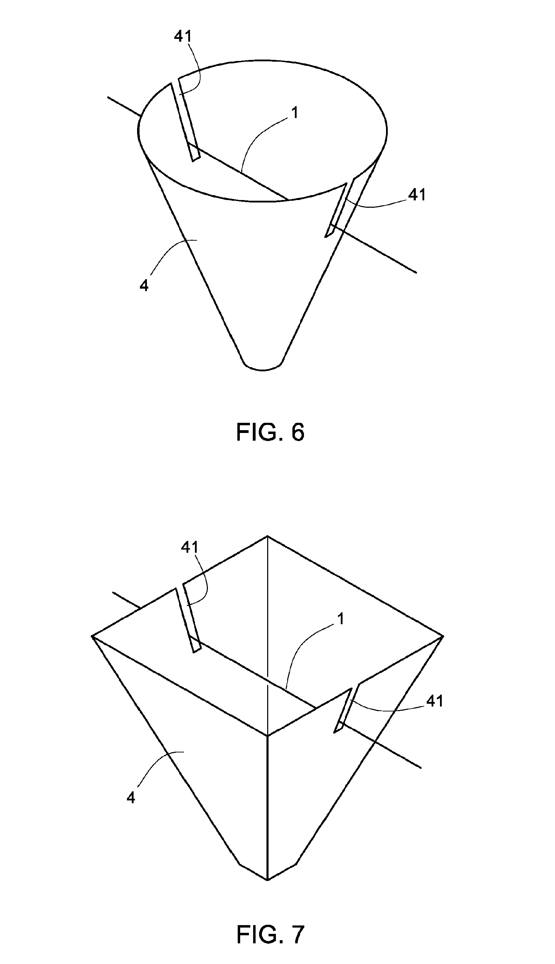

In addition, the cooling device of FIG. 4 has the diamond wire 1 arranged differently in the cooling tank 4. However, despite of the deployment of the diamond wire 1 in the cooling tank 4, the cutting part of the diamond wire 1 always remains in the cooling fluid. The cooling tank 4 may be approximately rectangular, or alternatively shaped as a taper cooling tank 4 as shown in FIG. 5. Such a taper cooling tank 4 may be a cone-like one as shown in FIG. 6, or a pyramid-like one as shown in FIG. 7. The taper cooling tank 4 may be atop provided with slots 41 that allow the diamond wire 1 to pass there through. The cooling fluid temporarily accumulating in the tank 4 overwhelms the diamond wire 1, and can drain out through the slots 41 or an opening at the bottom of the tank 4, so as to be collected in a fluid collecting tank 51 located above the sorting collector 5 and then subjected to the same sorting and recycling processes for the chips and the used fluid.

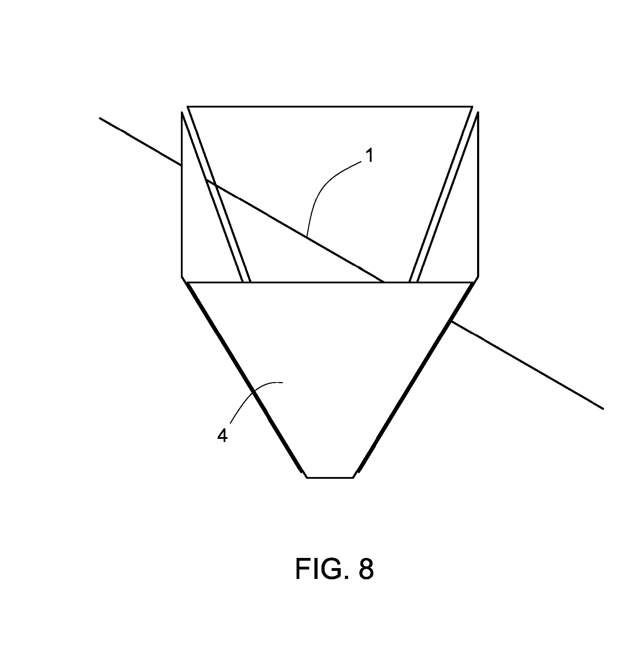

Furthermore, each said cooling tank 4 in FIGS. 3 through 7 is a fluid retarding space enclosed and thereby defined by a consecutive surface or a plurality of surfaces. The surface or the surfaces enclosing the cooling tank that provides a closed sidewall, and the cooling fluid flows out the tank 4 in a controlled manner so as to be temporarily held in the cooling tank 4, in turn making the cutting part of the diamond wire 1 stay in the cooling fluid. Alternatively, as shown in FIG. 8, the surface or the surfaces forming the cooling tank 4 that provides an open or semi-open sidewall, and overall have a downward taper geometry. The surfaces are disconnected or merely partially connected (not shown) with a gap having a predetermined width there between. Thus, after the cooling fluid is introduced into the cooling tank 4 enclosed by the surfaces, the cooling fluid flows out through the gaps. However, since the cooling fluid trickles slowly, the cooling fluid lingers and thereby accumulates in the cooling tank 4, thus overwhelming the cutting part of the diamond wire 1.

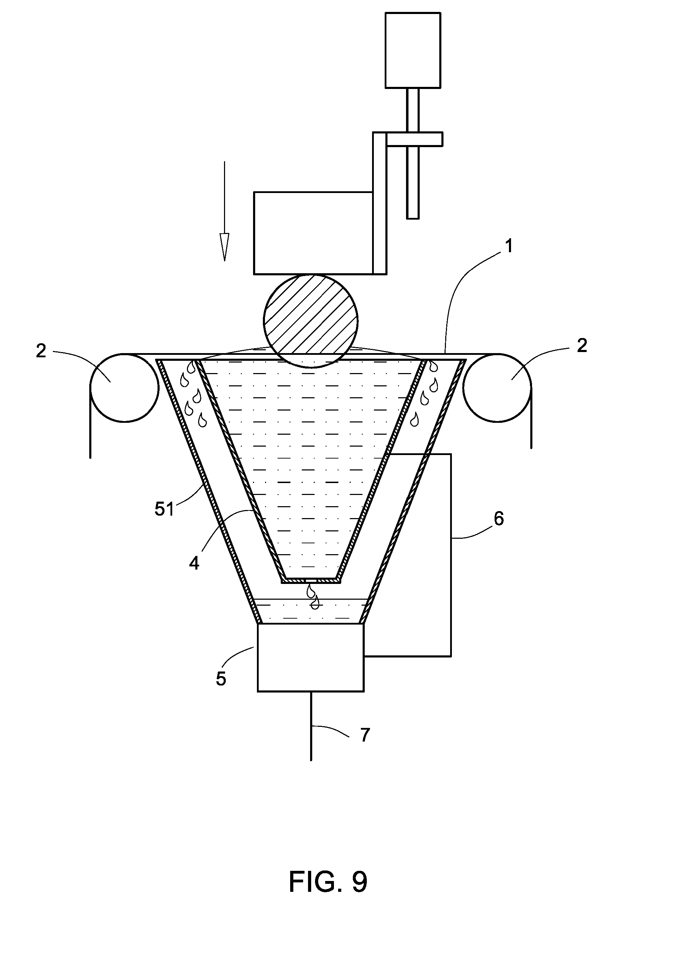

Moreover, as shown in FIG. 9, a fluid retarding space is enclosed and defined by a consecutive surface or a plurality of surfaces and the surface or the surfaces forming the cooling tank 4 that has a closed, open or semi-open sidewall. The cooling fluid flows out the tank 4 in a controlled manner so as to accumulate and thereby be temporarily held in the cooling tank 4 before spilling from the cooling tank 4, thereby forming a domed gush at the slot atop the cooling tank 4. As the diamond wire 1 passes through the gush, the cutting part of the diamond wire 1 can be similarly embraced by the gushing cooling fluid.

## Claims

1. A cooling device for a diamond-wire cutting system, the cooling device comprising a fluid retarding space that temporarily holds a cooling fluid so that a diamond wire of the cutting system has a cutting part thereof passing through the fluid retarding space and thereby immerging in the cooling fluid.

2. The cooling device of claim 1, wherein the fluid retarding space is enclosed and defined by a consecutive surface.

3. The cooling device of claim 1, wherein the fluid retarding space is enclosed and defined by a plurality of surfaces.

4. The cooling device of claim 2 or 3, wherein the surface or the surfaces form the fluid retarding space as a cooling tank that has a closed, open or semi-open sidewall.

5. The cooling device of claim 4, wherein a sorting collector is connected to a bottom of the cooling tank, the sorting collector having a recycling pipe running back to the cooling tank and having a chip recycling pipe connected to a bottom of the sorting collector.
